# EUROPEAN PATENT APPLICATION

(11) **EP 4 478 432 A1**
(43) Date of publication of application: **18.12.2024**
(21) Application number: 23750015.2
(22) Date of filing: 07.02.2023
(51) Int. Cl.: H01L 33/24, H01L 33/38, H01L 33/14, H05K 1/18, H01L 33/62, H01L 25/075

(54) **LIGHT-EMITTING DEVICE FOR EMITTING RED LIGHT, LIGHT-EMITTING MODULE HAVING SAME, AND DEVICE HAVING SAME**

(30) Priority: 07.02.2022 US 202263307497 P; 30.01.2023 US 202318161710
(71) Applicant: Seoul Viosys Co., Ltd., Ansan-si, Gyeonggi-do 15429 (KR)
(72) Inventor: YOO, Hong Jae, Ansan-Si Gyeonggi-do 15429 (KR); KO, Mi So, Ansan-Si Gyeonggi-do 15429 (KR); CHOI, Eun Mi, Ansan-Si Gyeonggi-do 15429 (KR); CHO, Sung Ryoung, Ansan-Si Gyeonggi-do 15429 (KR)
(74) Representative: Stolmár & Partner Patentanwälte PartG mbB
(86) International application number: PCT/KR2023/001733
(87) International publication number: WO 2023/149783

(57) **Abstract**

A red-light-emitting device according to one embodiment of the disclosure comprises a first conductive semiconductor layer, a second conductive semiconductor layer and an active layer arranged between the first conductive semiconductor layer and the second conductive semiconductor layer, wherein the first conductive semiconductor layer includes a plurality of protrusions on the surface thereof.

## Description

### [Technical Field]

The present disclosure relates to a light emitting device that emits red light.

### [Background Art]

Light emitting diodes are used in various technical fields in daily life, and for example, are used in various technical fields such as lighting, automobiles, light therapy, and displays.

In general, since a light emitting diode emits light having a single narrow full width at half maximum, it emits light of a single color in a visible light region. In order to implement various colors in many fields using light emitting diodes, a plurality of light emitting diodes having different peak wavelengths is used, or wavelength conversion materials such as phosphors are used together with the light emitting diodes.

Red light may be implemented using an AlGaInP-based semiconductor light emitting diode or using an InGaN-based light emitting diode emitting ultraviolet or blue light together with a phosphor. Currently used red light emitting diodes are required to further increase their efficiency. Meanwhile, since blue light and green light can be implemented with InGaN-based light emitting diodes, when red light is implemented with InGaN-based light emitting diodes, blue, green, and red may all be implemented with InGaN-based light emitting diodes, thereby simplifying the process.

### [DISCLOSURE]

### [Technical Problem]

Embodiments according to the present disclosure provide a red light emitting device having an improved radiation efficiency or a surface shape of a light emitting device, a light emitting module having the same, and an apparatus having the same.

Embodiments according to the present disclosure provide a light emitting device configured to implement various colors without a phosphor.

### [Technical Solution]

According to an embodiment of the present disclosure, a surface shape of a light emitting device including a plurality of protrusions is disclosed. The surface of the light emitting device may include a plurality of protrusions protruding upward from a surface of the light emitting device. According to this embodiment, the plurality of protrusions formed on the surface of the light emitting device may increase effects of both light scattering and light refraction of the light emitting device. The light emitting device on which the protrusion is formed is not limited to a light emitting device of a specific shape/type.

According to an embodiment, the plurality of protrusions may have inclined side surfaces. The side surface of the protrusion may be at least a portion of a surface connecting the surface of the light emitting device and an upper surface of the protrusion. As a result, the effects of scattering and refraction of emitted light may be increased.

According to an embodiment, the upper surfaces of the plurality of protrusions may be a combination of flat surfaces and curved surfaces. As a result, the effects of scattering and refraction of emitted light may be increased.

According to an embodiment, at least portions of the plurality of protrusions may be spaced apart from neighboring protrusions, and other portions may be disposed to be in contact with the neighboring protrusions. In a case that a protrusion is in contact with a neighboring protrusion, upper surfaces of the protrusions in contact may be connected to each other to have a continuous upper surface. At least portions of the plurality of protrusions may include a concave portion having a side surface concavely recessed with respect to an outer side of the protrusion and a convex portion protruding convexly with respect to the outer side. In this case, the upper surface of the protrusion may have, for example, a snowman shape as well as a circle or an oval. According to an embodiment, connection portions of the protrusions having the continuous upper surface may have a width smaller than a maximum width of the protrusions. For example, in a case of two protrusions in contact, a width of the protrusions at a center with respect to a longitudinal direction of the protrusion may be narrower than a width of an outer portion. However, the number of protrusions in contact with one another may be not only two, but three or more. According to this embodiment, a side surface area of the protrusion is increased, and thus, refraction over a variety of angle ranges may be effectively achieved.

According to an embodiment, the protrusions in contact with one another may include protrusions with V-shaped grooves formed between the protrusions. By forming the V-shaped groove, a light path may be more diversified, thereby improving a light extraction effect. In addition, according to an embodiment, a plurality of V-shaped grooves may be formed between the protrusions, and a depth of at least one V-shaped groove may be different from depths of the other V-shaped grooves. The light extraction effect may be further improved by forming the V-shaped grooves with different depths.

Configurations applied to the protrusion described in this disclosure may be implemented individually or in combination with other configurations.

According to an embodiment of the present disclosure, a red light emitting device including a plurality of protrusions is provided. Specifically, the red light emitting device according to an embodiment of the present disclosure may include: a first conductivity type semiconductor layer; a second conductivity type semiconductor layer; and an active layer disposed between the first conductivity type semiconductor layer and the second conductivity type semiconductor layer, in which the first conductivity type semiconductor layer may include a plurality of protrusions on a surface. The plurality of protrusions applied to the red light emitting device may include at least some of the configurations of the protrusions described above.

The plurality of protrusions may have inclined side surfaces.

The plurality of protrusions may include a protrusion spaced apart from other protrusions and protrusions contacting neighboring protrusions.

The protrusions contacting neighboring protrusions may include protrusions having a continuous upper surface.

Connection portions of the protrusions having the continuous upper surface may have a width smaller than a maximum width of the protrusions.

The protrusions contacting neighboring protrusions may include protrusions having V-shaped grooves formed therebetween.

The red light emitting device according to an embodiment may further include configurations described below, and the configurations below may be implemented in the red light emitting device individually or in combination with other configurations.

The red light emitting device may include a bonding pad disposed on the first conductivity type semiconductor layer and extension electrodes extending from the bonding pad. According to an embodiment, the extension pad may be configured in a comb-shape.

The bonding pad may be disposed near an edge or a vertex of the first conductivity type semiconductor layer.

The extension electrodes may include first extension electrodes extending in a first direction (e.g., longitudinal direction) from one edge of the first conductivity type semiconductor layer to an opposite edge thereof, and second extension electrodes connecting end portions of the first extension electrodes and extending in a second direction (e.g., transverse direction) perpendicular to the first direction.

At least one of the second extension electrodes may be connected to the bonding pad.

The second extension electrodes connected to the bonding pad may have a width that narrows as a distance from the bonding pad increases.

The bonding pad and the extension electrodes may be disposed on a flat region of the first conductivity type semiconductor layer, and the protrusions may be disposed in a region surrounded by the flat region. According to an embodiment, the first conductivity type semiconductor layer may include a region corresponding to a protrusion and a flat region. The bonding pads and the extension electrodes may be disposed on the flat region. The flat region may have, for example a comb-shape. In this case, the protrusion may be disposed between at least one pair of neighboring extension electrodes, and thus, the protrusion may be surrounded by the extension electrodes. Accordingly, light transmitted through the protrusion may be reflected by a side surface of the extension electrode, thereby increasing the light extraction efficiency.

According to an embodiment, the side surface of the extension electrode may be formed to have an inclination, and thus, the light extraction efficiency may be further improved. The side surface of the extension electrode may be individually designed depending on requirements regarding dispersion and extraction of light.

According to an embodiment, a light emitting device including a first conductivity type semiconductor layer, a second conductivity type semiconductor layer, an active layer disposed between the first conductivity type semiconductor layer and the second conductivity type semiconductor layer, and an insulation layer disposed on one surface of the second conductivity type semiconductor layer is provided.

According to an embodiment, the light emitting device including the insulation layer may have the above-described protrusions, but may not have the protrusions.

The red light emitting device according to this embodiment may further include a current blocking layer disposed under the second conductivity type semiconductor layer, and the current blocking layer may include at least two insulation layers having different refractive indices.

According to an embodiment, the current blocking layer may be formed in a region including a lower surface of the second conductivity type semiconductor layer. That is, the current blocking layer may include a region that overlaps with the second conductivity type semiconductor layer and a region that does not overlap. An entire region where the current blocking layer is formed may be, for example, a region corresponding to a substrate on which the light emitting device is stacked. A thickness of the current blocking layer may be formed larger in the region that overlaps with the second conductivity type semiconductor layer than in the region that does not overlap. The current blocking layer may receive less stress by having the thin thickness in the region that does not overlap with the second conductivity type semiconductor layer. As a result, a durability of the light emitting device, especially at edges thereof, may be improved.

The current blocking layer may include a SiO₂ layer and a Nb₂O₅ layer.

The red light emitting device may further include a substrate; a first metal layer disposed on the substrate; a second metal layer covering the current blocking layer; and a bonding metal layer bonding the first metal layer and the second metal layer.

The current blocking layer may have at least one opening, and the second metal layer may be electrically connected to the second conductivity type semiconductor layer through the opening of the current blocking layer.

The red light emitting device may further include an ohmic electrode in ohmic contact with the second conductivity type semiconductor layer, in which the opening of the current blocking layer may expose the ohmic electrode, and the second metal layer may be connected to the ohmic electrode.

According to an embodiment, the red light emitting device may include the protrusion, and a width of the opening may be larger than the width of one protrusion. That is, as the number of corresponding protrusions per unit area (or length) defined by the width of the opening increases, light diffused and refracted by each protrusion may be effectively extracted by the wide width.

A light emitting module according to an embodiment of the present disclosure includes: a circuit board; and a red light emitting device, a green light emitting device, and a blue light emitting device disposed on the circuit board, in which the red light emitting device is the red light emitting device described above.

A plant lighting apparatus according to an embodiment of the present disclosure includes: a panel substrate; and light emitting devices disposed on the panel substrate, in which the light emitting devices include first light emitting devices emitting white light, second light emitting devices emitting red light within a range of 630nm to 680nm, and third light emitting devices emitting longer wavelength red light within a range of 710nm to 750nm, and fourth light emitting devices emitting near ultraviolet light within a range of 380nm to 410nm, in which the second light emitting devices include the red light emitting device described above.

A peak wavelength of red light emitted from the second light emitting device may be longer than a peak wavelength of blue light emitted from the first light emitting device by 100nm or more, and a peak wavelength of near-ultraviolet light emitted from the fourth light emitting device may be shorter than the peak wavelength of blue light emitted from the first light emitting device by 50nm or more.

### [Description of Drawings]

FIG. 1A is a schematic plan view illustrating a light emitting device according to an embodiment of the present disclosure.
FIG. 1B is a schematic cross-sectional view taken along line A-A' of its corresponding view shown in FIG. 1A.
FIG. 2A is a schematic cross-sectional view illustrating a surface roughness according to an embodiment of the present disclosure.
FIG. 2B is a schematic cross-sectional view illustrating a protrusion according to an embodiment of the present disclosure.
FIG. 2C is a schematic cross-sectional view illustrating a protrusion according to another embodiment of the present disclosure.
FIG. 2D is a cross-sectional SEM image showing the surface roughness according to an embodiment of the present disclosure.
FIG. 2E is a planar SEM image showing the surface roughness according to an embodiment of the present disclosure.
FIG. 2F is an enlarged planar SEM image of a portion of FIG. 2E.
FIG. 3A is a schematic plan view illustrating a modified example of the light emitting device of FIG. 1.
FIG. 3B is a schematic plan view illustrating another modified example of the light emitting device of FIG. 1.
FIG. 4A is a schematic cross-sectional view illustrating a layer structure of an electrode extension of FIG. 1B.
FIG. 4B is a schematic cross-sectional view illustrating a current blocking layer of FIG. 1B.
FIG. 4C is a schematic cross-sectional view illustrating a metal bonding layer of FIG. 1B.
FIG. 5 is a schematic cross-sectional view illustrating a structure of a semiconductor stack of a light emitting device according to an embodiment of the present disclosure.
FIG. 6 is an enlarged cross-sectional view of a portion of FIG. 5.
FIG. 7 is a schematic cross-sectional view illustrating a structure of a semiconductor stack of a light emitting device according to an embodiment of the present disclosure.
FIG. 8 is a schematic cross-sectional view illustrating a color device according to another embodiment of the present disclosure.
FIG. 9A is a schematic band diagram illustrating a light emitting device according to an embodiment of the present disclosure.
FIG. 9B is a band diagram showing an enlarged light emitting region of FIG. 9A.
FIG. 10 is a cross-sectional view illustrating a structure of a semiconductor stack of a red light emitting device according to another embodiment of the present disclosure.
FIG. 11 is a schematic cross-sectional view illustrating a light emitting module having a red light emitting device according to an embodiment of the present disclosure.
FIG. 12 is a schematic plan view illustrating a display apparatus according to an embodiment of the present disclosure.
FIG. 13A are schematic perspective views illustrating various display apparatuses according to exemplary embodiments.
FIG. 13B is a schematic perspective view illustrating another display apparatus according to an exemplary embodiment.
FIG. 13C is a schematic perspective view illustrating another display apparatus according to an exemplary embodiment.
FIG. 14 is a schematic cross-sectional view illustrating a plant lighting apparatus according to an embodiment of the present disclosure.

### [Detailed Description of the Illustrated Embodiments]

Hereinafter, exemplary embodiments of the present disclosure will be described in detail with reference to the accompanying drawings. The following exemplary embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. In addition, when an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

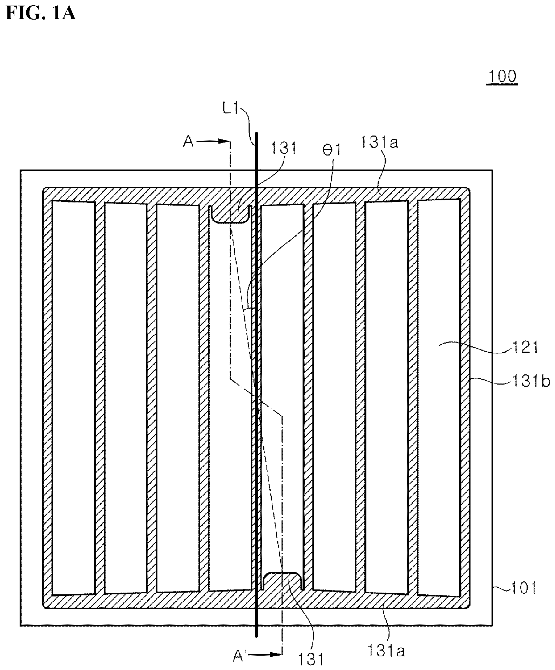

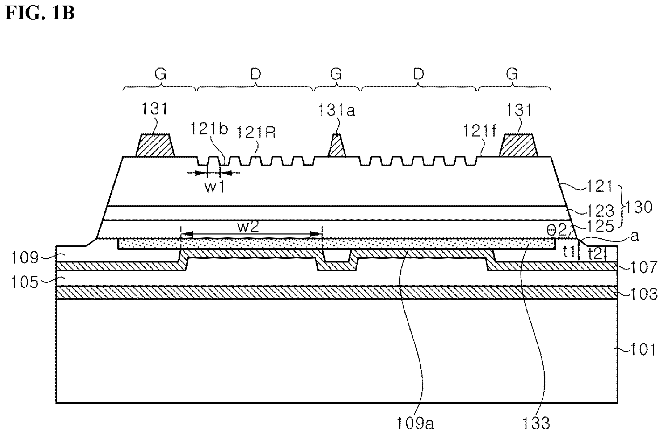

FIG. 1A is a schematic plan view illustrating a light emitting device 100 according to an embodiment of the present disclosure, and FIG. 1B is a schematic cross-sectional view taken along line A-A' of its corresponding view shown in FIG. 1A.

Referring to FIGs. 1A and 1B, the light emitting device 100 includes a substrate 101, a first metal layer 103, a bonding metal layer 105, a second metal layer 107, a current blocking layer 109, a semiconductor stack 130, a bonding pad 131, extension electrodes 131a and 131b, and an ohmic electrode 133.

The substrate 101 is a support substrate for supporting the semiconductor stack 130, without being particularly limited thereto, and may be, for example, a silicon substrate or a metal substrate. The substrate 101 may be a conductive substrate, without being limited thereto, and may also be an insulation substrate.

The semiconductor stack 130 includes a first conductivity type semiconductor layer 121, an active layer 123, and a second conductivity type semiconductor layer 125.

The first conductivity type semiconductor layer 121 may be, for example, an n-type semiconductor layer, and the second conductivity type semiconductor layer 125 may be a p-type semiconductor layer. Each of the first and second conductivity type semiconductor layers 121 and 125 may be a single layer, without being limited thereto, and may be multiple layers. The active layer 123 may have a single quantum well structure or a multi-quantum well structure, and may have a composition that emits light of a desired wavelength.

An upper surface of the first conductivity type semiconductor layer 121 may include a roughened surface 121R. The roughened surface 121R may be disposed in regions surrounded by the extension electrodes 131a and 131b, and the extension electrodes 131a and 131b and the bonding pads 131 may be disposed on a flat surface of the first conductivity type semiconductor layer 121. A refraction region 121F is defined by the flat surface of the first conductivity type semiconductor layer 121, and a scattering region D is defined by the roughened surface 121R. The refraction region is disposed along an edge of the semiconductor stack 130 and disposed under the extension electrodes 131a and 131b. The scattering regions D are formed between the refraction regions, and each of the scattering regions D may be surrounded by a refraction region G. Meanwhile, the scattering region D may include flat surfaces in the roughened surface 121R, and these flat surfaces form an additional refraction region G-1.

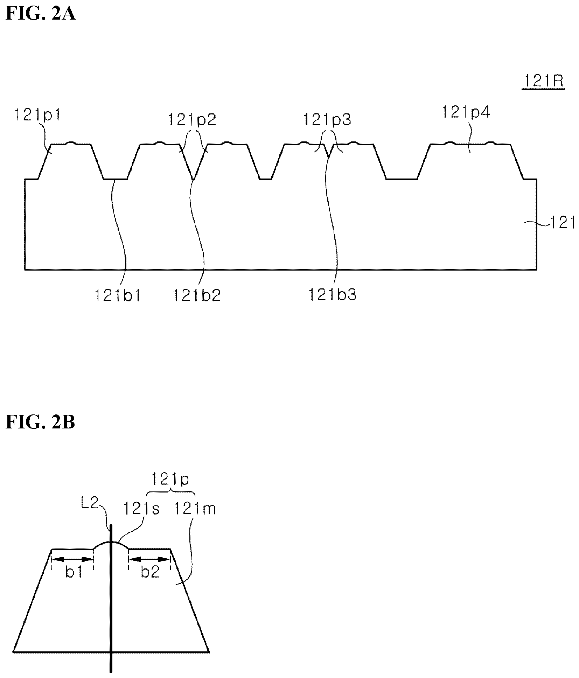

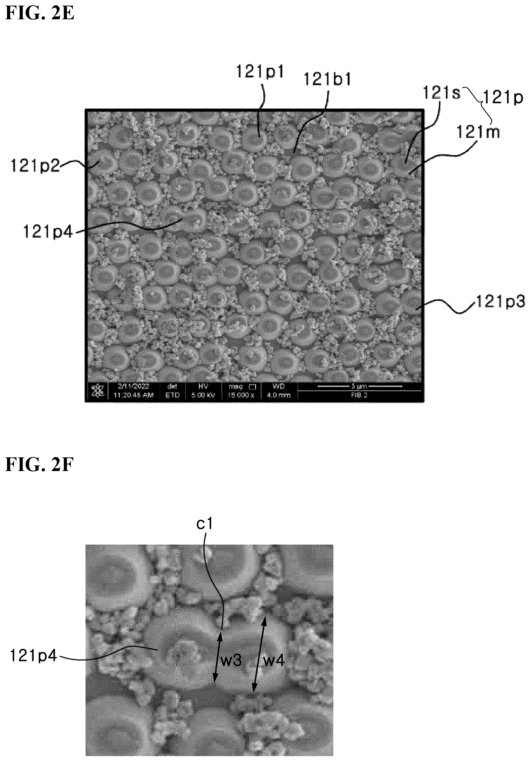

As shown in FIG. 2A, the roughened surface 121R may include variously disposed protrusions 121p1, 121p2, 121p3, and 121p4. The protrusions 121p1, 121p2, 121p3, and 121p4 may have edges formed as curved surfaces in plan view, and may have inclined side surfaces in crosssection view. The side surfaces of the protrusions 121p1, 121p2, 121p3, and 121p4 may be at least a portion of a surface connecting a surface of the light emitting device and upper surfaces of the protrusions. Herein, at least one protrusion 121p1 may be surrounded by a flat bottom surface 121b1, and may be spaced apart from neighboring protrusions. The flat bottom surface 121b1 forms an additional refraction region. The additional refraction region may surround at least one of the protrusions 121p1, 121p2, 121p3, and 121p4. As a result, effects of scattering and refraction of emitted light may be increased. In addition, the upper surfaces of the plurality of protrusions 121p1, 121p2, 121p3, and 121p4 may be a combination of flat surfaces and curved surfaces. As a result, the effects of scattering and refraction of emitted light may be increased.

The protrusion 121p2 is disposed close to a neighboring protrusion, and a region between the protrusions 121p2 forms a V-shaped groove. A bottom point 121b2 of the groove may be disposed at a same depth as that of the bottom surface 121b1. Meanwhile, the protrusion 121p3 is formed in contact with a neighboring protrusion, and the region between the protrusions 121p2 forms a V-shaped groove, but a depth of a bottom point 121b3 is smaller than that of the bottom surface 121b1.

By forming the V-shaped groove, a light path may be more diversified, thereby improving light extraction effect. In addition, according to an embodiment, a plurality of V-shaped grooves may be formed between the protrusions, and a depth of at least one V-shaped groove may be different from depths of the other V-shaped grooves. The light extraction effect may be further improved by forming the V-shaped grooves with different depths.

The protrusion 121p4 may be adjacent to a neighboring protrusion to form one upper surface. Specifically, at least portions of the plurality of protrusions may be spaced apart from neighboring protrusions, and other portions may be disposed to be in contact with the neighboring protrusions. In a case that a protrusion is in contact with a neighboring protrusion, upper surfaces of the protrusions in contact may be connected to each other to have a continuous upper surface. At least portions of the plurality of protrusions may include a concave portion having a side surface concavely recessed with respect to an outer side of the protrusion and a convex portion protruding convexly with respect to the outer side. In this case, the upper surface of the protrusion may have, for example, a snowman shape as well as a circle or an oval. According to an embodiment, connection portions of the protrusions having the continuous upper surface may have a width smaller than a maximum width of the protrusions. For example, in a case of two protrusions in contact, a width of the protrusions at a center with respect to a longitudinal direction of the protrusion may be narrower than a width of an outer portion. However, the number of protrusions in contact with one another may be not only two, but three or more. According to this embodiment, a side surface area of the protrusion is increased, and thus, refraction over a variety of angle ranges may be effectively achieved.

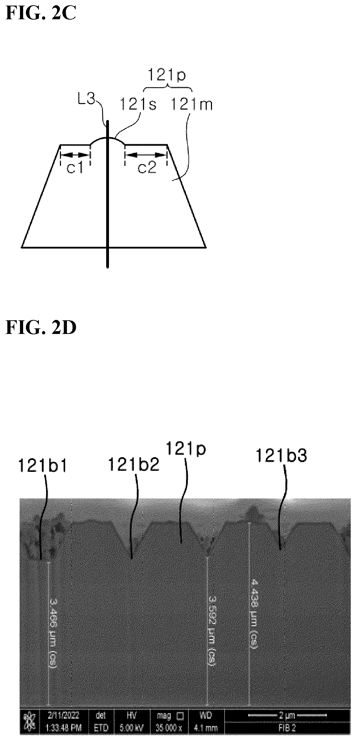

FIGs. 2D and 2E are SEM images showing the roughened surface 121R of an actually fabricated semiconductor stack 130, and various types of protrusions 121p1, 121p2, p121p3, and 121p4 can all be observed, in addition, the bottom surface 121b1 and the bottom points 121b2 and 121b3 can be observed. As shown in FIG. 2E, when a plurality of protrusions 121p4 is connected to one another, the plurality of protrusions 121p4 is connected by a connection portion c1 in plan view. A width w3 of the connection portion c1 of the protrusions 121p4 may be smaller than a maximum width w4 of the protrusions 121p4.

The roughened surface 121R of the present disclosure may have the protrusions 121p1, and in another embodiment, may also include at least one type of protrusion among the protrusions 121p2, 121p3, and 121p4 disposed in close proximity to neighboring protrusions along with the protrusions 121p1. Accordingly, extraction efficiency of light emitted from the semiconductor stack 130 to the outside may be improved.

As shown in FIGs. 2B and 2C, at least one protrusion 121p may include a main protrusion 121m and a sub protrusion 121s. The main protrusion 121m may have a substantially trapezoidal cross-sectional shape, and the sub protrusion 121s may have a shape protruding from an upper surface of the main protrusion 121m. The main protrusion 121m includes an inclined side surface, and may have, for example, a truncated cone shape. Meanwhile, the sub protrusion 121s may have a convex shape, without being limited thereto, and may have various shapes. For example, the main protrusion 121m may be formed using photolithography and etching processes, and the sub protrusion 121s may be formed using a dry or wet etching technique. After the main protrusion 121m is formed, photoelectrochemical (PEC) etching may be performed to further form roughened surfaces on a surface of the main protrusion 121m and the bottom surface 121b 1.

Referring to FIG. 2B, at least one protrusion 121p may be substantially symmetrical with respect to an imaginary center line L2. Accordingly, distances b1 and b2 between an outer boundary of the sub protrusion 121s and an outer boundary of the upper surface of the main protrusion 121m may be substantially same. Accordingly, an uniformity of an emission pattern may be improved.

Referring to FIG. 2C, in another embodiment, at least one protrusion 121p may be substantially left-right asymmetric with respect to a virtual center line L3. Accordingly, distances c1 and c2 between the outer boundary of the sub protrusion 121s and the outer boundary of the upper surface of the main protrusion 121m may be different from each other. As a result, a distance between side surfaces of the sub protrusion 121s and the main protrusion 121m is changed, and since lengths of paths of light hovering around the protrusion after entering the protrusion until being emitted are variously formed, a degree of scattering may be improved.

The sub-protrusions 121s may have irregular shapes and may have different shapes, and accordingly, since a critical angle effective for light scattering and extraction at an interface of the sub-protrusions 121s may be included in a wide variety of ranges, light scattering may be more effective. A width w1 of one protrusion 121p may be smaller than a width w2 of an opening of the current blocking layer 109. Furthermore, the width w1 of one protrusion 121p may be less than 1/2 of the width w2 of the opening of the current blocking layer 109. By making the width of each protrusion 121p smaller than an area where a light-reflective material of the second metal layer 107 faces the semiconductor stack 130 through the opening of the current blocking layer 109, an effect of scattering and extracting light reflected from the second metal layer 107 may be increased. In other words, as the number of corresponding protrusions per unit area (or length) defined by the width of the opening increases, light diffused and refracted by each protrusion may be effectively extracted by the wide width.

The semiconductor stack 130 may include, for example, AlGaInP-based semiconductor layers or AlGaInN-based semiconductor layers emitting red light. Specific configurations of these semiconductor stacks 130 will be described in detail later.

Referring back to FIGs. 1A and 1B, the bonding pads 131 and the electrode extensions 131a and 131b are disposed on the first conductivity type semiconductor layer 121. As shown in FIG. 1A, the bonding pads 131 may be disposed near opposite edges of the semiconductor stack 130. By disposing the bonding pads 131 near the edges of the semiconductor stack 130, a light blocking effect by the bonding pads 131 may be reduced. The electrode extensions 131a extend from the bonding pads 131 in a transverse direction, and the electrode extensions 131b extend from the bonding pads 131 or the electrode extensions 131a in a longitudinal direction. The electrode extensions 131b may extend in a direction perpendicular to edges where the bonding pads 131 are disposed, and the electrode extensions 131a may connect ends of the electrode extensions 131b. In an embodiment, outer two electrode extensions 131b together with the electrode extensions 131a may define a quadrangular region. According to an embodiment, the electrode extensions 131a and 131b may be configured in a comb-shape.

Meanwhile, the electrode extensions 131a may include a region of varying widths, and may have, for example, a shape in which a width thereof becomes narrower as a distance from the bonding pads 131 increases. The electrode extensions 131b may extend with a same width, but the inventive concepts are not limited thereto. The electrode extensions 131a and 131b spread current introduced through the bonding pads 131 over a wide region of the first conductivity type semiconductor layer 121. The electrode extensions 131a and 131b may have the widths within a range of about 5um to about 10um. When the widths of the electrode extensions 131a and 131b exceed 10um, emission of light generated from the semiconductor stack 130 is hindered, thereby reducing luminous efficiency, and when the widths are less than 5um, it is difficult to provide an area sufficient to spread current.

In this embodiment, the bonding pads 131 may be disposed between two electrode extensions 131b. That is, a width of the bonding pad 131 may be narrower than a width of a region between the two electrode extensions 131b. The bonding pads 131 may be alternately disposed with a line L1 passing through a center of the semiconductor stack 130 interposed therebetween. The bonding pads 131 may be disposed symmetrically with one another, and for example, may be disposed rotationally symmetrically by 180 degrees. An offset angle Θ1 of the bonding pad 131 with respect to the line L1 may be within a range of 0° to 30°. In a case that the angle O1 is greater than 30°, an internal resistance of a current path for current to reach a central region of the ohmic electrode 133 increases when current is injected into the bonding pad 131 and supplied to the inside of the semiconductor layer, and thus, uniform light emission may be difficult. Accordingly, light emission uniformity may be improved by disposing the angle Θ1 to be smaller than 30°. However, the inventive concepts are not limited thereto, and the bonding pads 131 may be disposed on the line L1 passing through the center.

A side surface of the semiconductor stack 130 of the light emitting device may be inclined. An inclination angle Θ2 may be within a range of 60° to 75° based on a flat upper or lower surface of the semiconductor stack 130. In addition, a width of the semiconductor stack 130 may become narrower toward the electrode pad 131 from the substrate. Accordingly, an amount of light may be secured by making a width of a position where the active layer 123 generating light is disposed in the semiconductor stack 130 wider than a width of a light exiting surface.

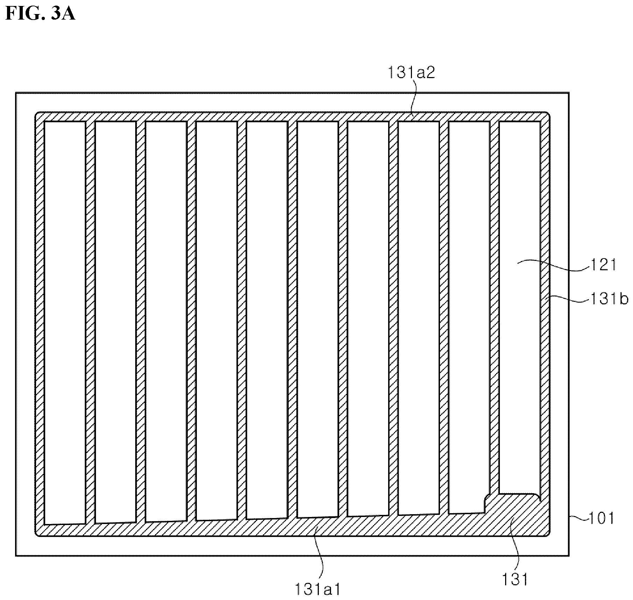

Meanwhile, as shown in FIG. 3A, a single bonding pad 131 may be disposed near a vertex of the semiconductor stack 130. An electrode extension 131a1 may extend in a transverse direction from the bonding pad 131, and may include a region in which a width changes. By disposing the bonding pad 131 near the vertex of the semiconductor stack 130, blocking of light generated in the semiconductor stack 130 by the bonding pad 131 may be minimized. Meanwhile, an electrode extension 131a2 connects ends of the electrode extension portions 131b, but is spaced apart from the bonding pad 131. The electrode extension 131a2 may extend with a certain width, but the inventive concepts are not necessarily limited thereto.

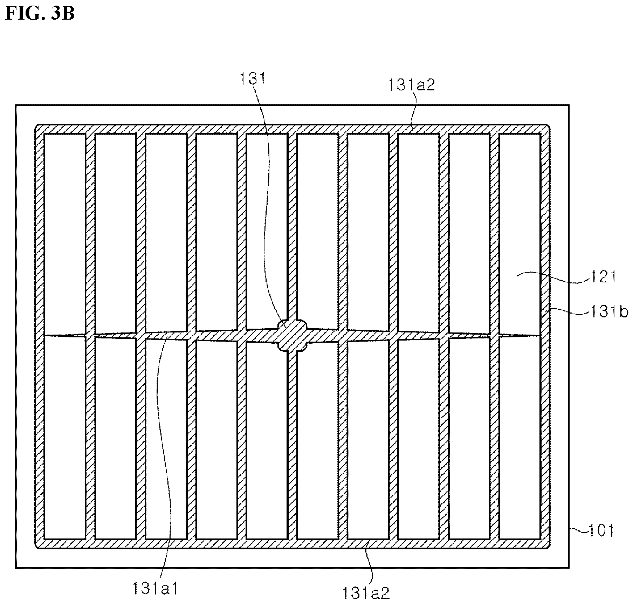

In another embodiment, as shown in FIG. 3B, the bonding pad 131 may be disposed in a central region of the semiconductor stack 130. The electrode extension 131a1 may extend from the bonding pad 131 in a transverse direction. Meanwhile, the electrode extensions 131a2 may connect the ends of the electrode extensions 131b. By disposing the bonding pad 131 in the central region of the semiconductor stack 130, current may be uniformly supplied over an entire region of the semiconductor stack 130.

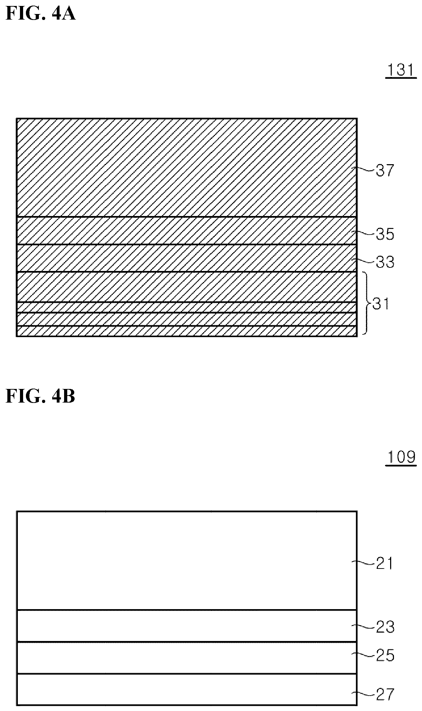

The bonding pad 131 and the electrode extensions 131a and 131b may have a metallic stack structure. The bonding pad 131 and the electrode extensions 131a and 131b may be formed together in a same process, and may be formed using a photolithography and development or a lift-off technique. In an embodiment, as shown in FIG. 4A, the bonding pad 131 may include an ohmic electrode layer 31, a barrier layer 33, a cover layer 35, and an electrode layer 37. The ohmic electrode layer 31 and the first conductivity type semiconductor layer 121 may form non-uniform interfaces, thereby increasing a contact area. The ohmic electrode layer 31 may include a material having a lower melting point than that of the electrode layer 37, for example, Ge. It is advantageous for ohmic formation by including a soft metal, and it is advantageous for ohmic formation because it may intrude between the non-uniform interfaces. The ohmic electrode layer 31 may include, for example, Au/Ni/Ge/Ti.

The barrier layer 33 may have a thickness of about 150nm or more, and may include a same material as that of a material layer in the ohmic electrode layer 31. For example, the barrier layer 33 may include Ti. The cover layer 35 may be thinner than the barrier layer 33, and may have a highest melting point within the bonding pad 131. The melting point increases from the barrier layer 33 to the cover layer 35 in a region between the ohmic electrode layer 31 and the electrode layer 37, and accordingly, peeling of the electrode layer 37 may be prevented.

The electrode layer 37 may have a thickness of 1.5um or more, and may be 10 times or more thicker than that of the barrier layer 33. The electrode layer 37 may be formed of a metallic layer having a high reflectance of about 92% or more for light emitted from the semiconductor stack 130, for example, Au. A reflectance of the electrode layer 37 may be higher than that of the cover layer 35 with respect to a peak wavelength of light emitted from the semiconductor stack 130. The electrode layer 37 may have an inclined side surface, and an inclination angle may be within a range of 75 degrees to 85 degrees with respect to an upper surface of the semiconductor stack 130. The inclined side surface of the electrode layer 37 improves reflectivity of light emitted from the semiconductor stack 130 to the outside. A total thickness of each of the bonding pad 131 and the electrode extensions 131a and 131b may be smaller than a thickness of the semiconductor stack 130.

Referring back to FIGs. 1A and 1B, the ohmic electrode 133 may be in ohmic contact with the second conductivity type semiconductor layer 125 of the semiconductor stack 130. The ohmic electrode 133 may be formed of, for example, a light-transmitting material such as ITO or ZnO or a light-reflective material such as metal.

The current blocking layer 109 is disposed under the semiconductor stack 130. The current blocking layer 109 is disposed between the substrate 101 and the semiconductor stack 130, and is formed of an insulation layer. The current blocking layer 109 may cover the ohmic electrode 133, and may have at least one opening 109a exposing the ohmic electrode 133. The current blocking layer 109 is disposed vertically under the bonding pad 131 and the electrode extensions 131a and 131b to prevent current from flowing in a vertical direction. The current blocking layer 109 assists to spread current over the wide region of the semiconductor stack 130. A plurality of openings 109a may be disposed under regions between the electrode extensions 131a and 131b. The openings 109a may be formed to have an elongated shape in a same direction as that of the electrode extension 131b, without being limited thereto. For example, the plurality of openings 109a may be disposed apart from one another in the lateral and longitudinal directions. A transverse width of the openings 109a is smaller than a width of a region between the electrode extensions 131b.

The current blocking layer 109 may be formed of a single layer, for example, an oxide or nitride such as SiO₂ or Si₃N₄, or may be formed of multiple layers. For example, the current blocking layer 109 may have a multilayer structure that reflects light generated in the semiconductor stack 130. As shown in FIG. 4B, the current blocking layer 109 may include a plurality of layers 21, 23, 25, and 27. A first layer 21 closest to the semiconductor stack 130 may be thicker than the other layers, and in an embodiment, thicker than a sum of the other layers. An electrical short circuit may be effectively prevented by increasing a thickness of the first layer 21 closest to the semiconductor stack 130. The first layer 21 and a third layer 25 may be formed of a layer having a same refractive index, for example SiO₂, and a second layer 23 and a fourth layer 27 may be formed of a layer having a same refractive index, for example TiO₂ or Nb₂O₅. TiO₂ and Nb₂O₅ have a high refractive index and relatively low light absorption, thereby making them suitable for preventing light loss. In addition, the current blocking layer 109 having a high reflectance may be provided by alternately disposing layers having different refractive indices.

The current blocking layer 109 may include regions having different thicknesses. That is, the current blocking layer 109 may include a region having a first thickness t1 and a region having a relatively smaller second thickness t2. The regions of different thicknesses of the current blocking layer 109 may be disposed in a region vertically overlapping the semiconductor stack 130. According to an embodiment, the current blocking layer 109 may be formed in a region including a lower surface of the second conductivity type semiconductor layer. That is, the current blocking layer 109 may include a region that overlaps with the second conductivity type semiconductor layer and a region that does not overlap. An entire region where the current blocking layer 109 is formed may be, for example, a region corresponding to a substrate on which the light emitting device is stacked. The thickness of the current blocking layer 109 may be formed larger in the region that overlaps with the second conductivity type semiconductor layer than in the region that does not overlap. The current blocking layer may receive less stress by having the thin thickness in the region that does not overlap with the second conductivity type semiconductor layer. As a result, a durability of the light emitting device, especially at edges or corners thereof, may be improved.

In another embodiment, the regions of different thicknesses of the current blocking layer 109 may be disposed apart from the semiconductor stack 130 in a lateral direction, or may be disposed outside a boundary of an outer surface of the semiconductor stack 130. An upper surface of the current blocking layer 109 may be formed as an inclined surface between the first thickness t1 and the second thickness t2. The inclined surface may have a gentler angle than an inclined sideΘ2 of the semiconductor stack 130. Accordingly, in a case that a protection layer is formed on a light exiting surface of the light emitting device, even when the protection layer extends from the inclined side of the semiconductor stack 130 to an outward of the semiconductor stack 130, an occurrence of cracks in the protection layer may be prevented due to a region where the thickness of the current blocking layer 109 changes, thereby increasing a reliability of the device.

The first metal layer 103 may be formed on the substrate 101, the second metal layer 107 may be disposed on the current blocking layer 109, and the first metal layer 103 and the second metal layer 107 may be bonded through the bonding metal layer 105. The bonding metal layer 105 may include a material having a highest melting point (e.g., Au) and a material having a melting point lower than a middle of the melting point (e.g., Sn or In). The bonding metal layer 105 may be formed of, for example, AuSn or AuSnIn.

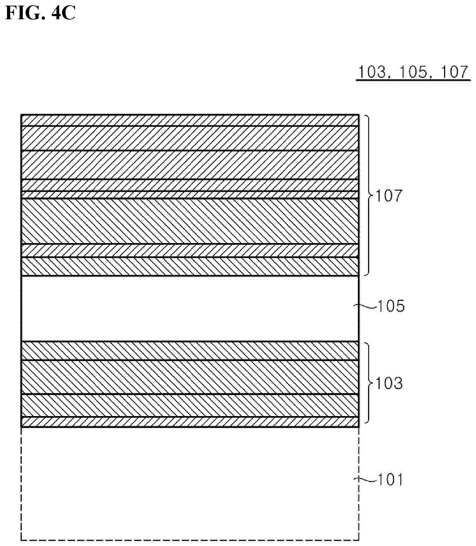

As shown in FIG. 4C, the first metal layer 103 and the second metal layer 107 may be formed of multiple layers. For example, the first metal layer 103 may include Pt, Au, Ti, and Ni layers from the substrate 101.

The second metal layer 107 may cover the current blocking layer 109, and may be electrically connected to the ohmic electrode 133 through the openings 109a. The ohmic electrode 133 may be omitted, and the second metal layer 107 may be in ohmic contact with the second conductivity type semiconductor layer 125 through the openings 109a. The second metal layer 107 may include, for example, a reflective metallic layer such as Al or Ag, and a Pt layer may be disposed between the Ti:W layers. For example, the second metal layer 107 may include Al/Ag/TiW/Pt/Ti/TiW/Ti/Ni from the current blocking layer 109. An inclination angle of the second metal layer 107 formed on a side surface of the opening 109a may be smaller than the inclination angle of the side surface of the semiconductor stack 130, and an inclination angle of a side surface of the bonding pad 131 may be larger than the inclination angle of the side surface of the semiconductor stack 130. Light extraction to the side surface of the semiconductor stack 130 may be assisted by making the inclination angle of the side surface of the semiconductor stack 130 intermediate between the inclination angle of the second metal layer 107 and the inclination angle of the side surface of the bonding pad 131.

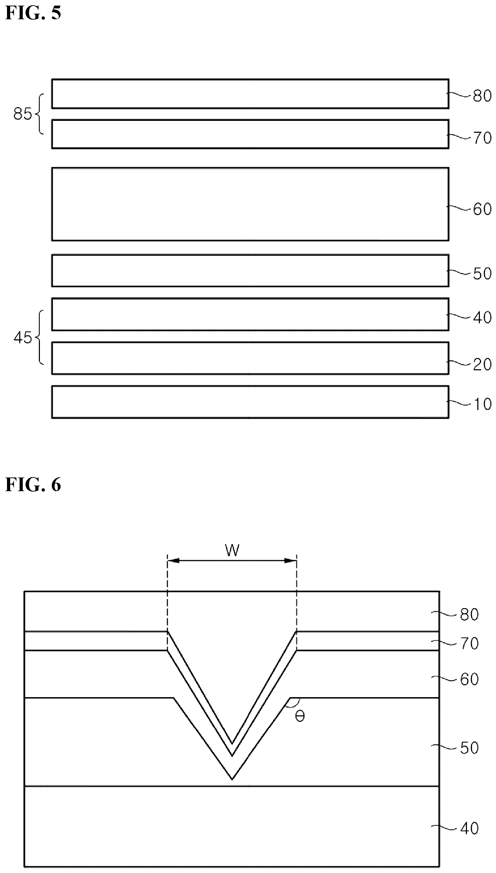

FIG. 5 is a schematic cross-sectional view illustrating a structure of a semiconductor stack of a light emitting device according to an embodiment of the present disclosure.

Referring to FIG. 5, according to this embodiment, the structure of the semiconductor stack may be provided from gallium nitride-based semiconductor layers formed on a growth substrate 10. The semiconductor layers may include a buffer layer 20, a first conductivity type semiconductor layer 40, a pre-strained layer 50, an active layer 60, an electron blocking layer 70, and a second conductivity type semiconductor layer 80.

The growth substrate 10 may include a SiC substrate, a sapphire substrate, a silicon substrate, a GaN substrate, a GaAs substrate, and the like. The growth substrate 10 is not particularly limited as long as it is a substrate capable of growing a gallium nitride-based semiconductor layer. The growth substrate 10 may finally be removed from the semiconductor stack.

The buffer layer 20 is a low-temperature buffer layer for growing a semiconductor layer on a heterogeneous substrate, for example, a nucleation layer, and may be formed of, for example, an undoped AlGaN layer. A high-temperature buffer layer, for example, an undoped GaN layer, may be further formed on the buffer layer 20.

The first conductivity type semiconductor layer 40 may serve as a contact layer for supplying electricity to the active layer 60. The first conductivity type semiconductor layer 40 may include a III-V material such as AlxIn(y)Ga(1-x-y)N (x, y>=0), and may be doped with a dopant such as Si. The buffer layer 20 and the first conductivity type semiconductor layer 40 may form a first conductivity type semiconductor region 45.

The active layer 60 may be formed on the first conductivity type semiconductor layer 40. The active layer 60 may include a III-V material such as AlxIn(y)Ga(1-x-y)N (x, y>=0). The active layer 60 may include at least one well layer emitting red light. Furthermore, the active layer 60 may include a first light emitting portion and a second light emitting portion emitting light of different colors from each other. Each of the light emitting portions may have different types of materials that determine a peak wavelength, CIE, or CRI of emitted light, or may have different amounts of the materials. For example, the first light emitting portion and the second light emitting portion may emit light having different peak wavelengths, and a light emitting material of the first light emitting portion may emit light having a shorter wavelength than that of a light emitting material of the second light emitting portion. For example, the first light emitting portion may emit blue light, and the second light emitting portion may emit red light.

The electron blocking layer 70 may be formed on the active layer 60. The electron blocking layer 70 serves as a resistor in a flow of current, and may function as a barrier to prevent electrons injected from the first conductivity type semiconductor layer 40 from flowing into the second conductivity type semiconductor layer 80. The electron blocking layer 70 may include a III-V material such as AlxIn(y)Ga(1-x-y)N (x>=0), and may have an energy band gap wider than those of the first and second conductivity type semiconductor layers 40 and 80. For example, an energy band gap of at least one layer of the electron blocking layer 70 may be wider than that of at least one layer of the first and second conductivity type semiconductor layers 40 and 80 by 0.9 eV or more. The electron blocking layer 70 may be formed of a single layer or a plurality of layers. When formed of the plurality of layers, it may include a plurality of layers having different Al contents or band gap energies, and in this case, a layer having a relatively high Al content or a layer having a relatively wide band gap energy may be disposed close to the active layer 60. A difference in Al contents between the layer with a relatively high Al content and a layer with a relatively low Al content may be within 10%, or a difference in band gap energies may be within 0.6 eV. In another embodiment, a profile of the Al content of the electron blocking layer 70 may be substantially similar to a profile of an In content of the electron blocking layer 70. That is, the In content may be relatively high where the Al content is relatively high, and the In content may be relatively low where the Al content is relatively low. However, the inventive concepts are not necessarily limited thereto, and the profile of the Al content and the profile of the In content may be different.

The pre-strained layer 50 may be formed as a single layer or multiple layers. The pre-strained layer 50 may include a VGL (V-pit generation layer) for generating V-pits. The VGL may be formed of a GaN layer or a single layer of an InGaN layer or multiple layers including the GaN layer and the InGaN layer, and may be formed at a temperature lower than a growth temperature of the first conductivity type semiconductor layer 40, for example, about 900° C or less. By growing the VGL at a relatively low temperature, densities of threading dislocations may be lowered and V-pits may be generated. The pre-strained layer 50 may also include an intermediate layer for compensating strain caused by the active layer 60. The intermediate layer may be formed of a nitride-based semiconductor layer having a lattice constant smaller than that of the active layer 60, and further, may be formed of a nitride-based semiconductor layer having a lattice constant smaller than that of the first conductivity type semiconductor layer 40. The intermediate layer may include, for example, an AlN layer and/or an AlGaN layer.

A width W of an inlet of the V-pit may increase in proportion to a thickness of the VGL. Since a thickness of the intermediate layer is relatively small, it can be seen that the width of the inlet of the V-pit increases in proportion to a thickness of the pre-strained layer 50. For example, 80% or more of the V-pits in a 100um × 100um region may have the widths W within ±10% of the thickness of the VGL or the thickness of the pre-strained layer 50. In addition, an angle Θ formed between an inclined surface of the V-pit and a flat surface of the pre-strained layer 50 may be within a range of 120° to 150°. As described later, the semiconductor stack may have a high luminous intensity within a specific size range of V-pits.

Meanwhile, when a size of the V-pits increases, a density of the V-pit may decrease. That is, by adjusting the thickness of the VGL, the density of the V-pit is adjusted. Furthermore, the V-pits formed by the pre-strained layer 50 relieve strain to assist more indium to be introduced into the active layer formed thereon. Accordingly, a multi-quantum well structure of a higher indium content may be included in the active layer 60, and thus, long-wavelength visible light such as red light may be easily implemented.

The second conductivity type semiconductor layer 80 may be formed on the electron blocking layer 70. The second conductivity type semiconductor layer 80 may have a polarity opposite to that of the first conductivity type semiconductor layer 40, and may include, for example, a material such as Mg, B, or the like. The electron blocking layer 70 and the second conductivity type semiconductor layer 80 may form a first conductivity type semiconductor region 85. The material such as Mg, B, or the like of the second conductivity type semiconductor layer 80 may have an inclined profile, and may have a left-right asymmetrical profile with respect to a peak point having a highest content of the material. Preferably, an inclination of a profile in a direction closer to the active layer 60 with respect to the peak point may be relatively gentler than an inclination of a profile disposed opposite to the peak point.

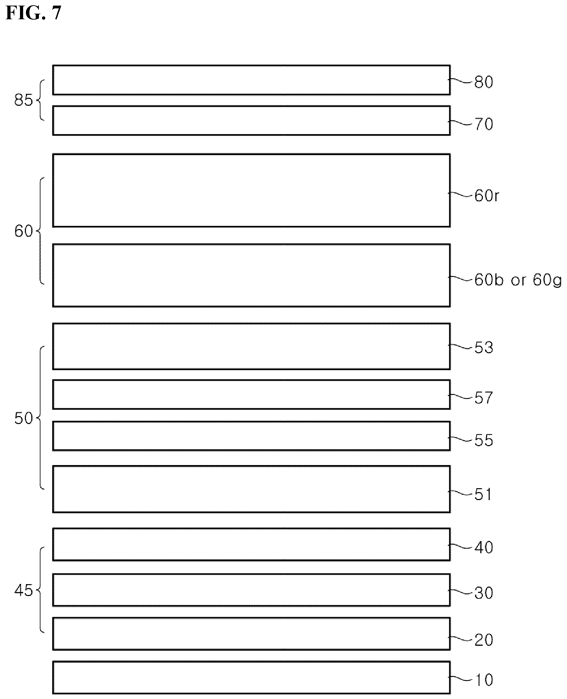

Hereinafter, a specific example of a structure of a semiconductor stack will be described in more detail with reference to FIG. 7. FIG. 7 is a schematic cross-sectional view illustrating a structure of a semiconductor stack of a light emitting device according to an embodiment of the present disclosure.

Referring to FIG. 7, the structure of the semiconductor stack according to this embodiment may be grown on the growth substrate 10 as described with reference to FIG. 5, and may include a first conductivity type semiconductor region 45, a pre-strained layer 50, an active layer 60, and a second conductivity type semiconductor region 85.

Since the growth substrate 10 is same as that described with reference to FIG. 5, a detailed description thereof will be omitted to avoid redundancy. The first conductivity type semiconductor region 45 may include a buffer layer 20, an undoped GaN layer 30, and a first conductivity type semiconductor layer 40. The first conductivity type semiconductor region 45 of this embodiment is same as the first conductivity type semiconductor region 45 described with reference to FIG. 5 except that the undoped GaN layer 30 is clearly shown in the drawing, and a detailed description thereof is omitted.

The pre-strained layer 50 may be formed of a plurality of layers. As shown in FIG. 7, the pre-strained layer 50 may include a first V-pit generation layer (VGL) 51, a first intermediate layer 55, a second intermediate layer 57, and a second VGL 53. Each layer of the pre-strained layer 50 may be formed of AlxInyGa(1-x-y)N (x, y>=0), and the first and second intermediate layers may include layers having different band gap energies from each other, respectively.

As shown in FIG. 7, among the layers of the pre-strained layer 50, the first VGL 51 may be disposed closest to the first conductivity type semiconductor layer 40, and the second VGL 53 may be closest to a second conductivity type semiconductor layer 80. The first intermediate layer 55 and the second intermediate layer 57 may be disposed between the first VGL 51 and the second VGL 53. An additional layer may be further included between these layers, but the inventive concepts are not necessarily limited thereto.

The first VGL 51 may be grown at a temperature lower than a growth temperature of the first conductivity type semiconductor layer 40, for example, 900°C or lower, and may include a GaN layer. The first VGL 51 may be formed using a TMGa source to increase a growth rate, which may adjust a size and a density of a V-pit, for example. The first VGL 51 may be formed to have a thickness within a range of about 1000Å to about 2500Å. The first VGL 51 may have a same energy band gap as that of the first conductivity type semiconductor layer 40, and may have a thickness greater than that of each well layer of the active layer 60. Accordingly, the first VGL 51 may transmit light having a wavelength in a red region and may relieve strain formed in the active layer 60.

The first intermediate layer 55 or the second intermediate layer 57 is a layer added to substantially control strain, and may be formed of AlN, AlxGa(1-x)N, or GaN. The first and second intermediate layers 55 and 57 may have a thickness of about 10Å to about 150Å, and about 30Å to about 450Å, respectively. The first and second intermediate layers 55 and 57 may have a thickness smaller than that of the active layer 60 including well layers and barrier layers.

The first and second intermediate layers 55 and 57 may have an energy band gap higher than those of the well layers of the active layer 60, and further, may have the energy band gap higher than those of the barrier layers of the active layer 60, and furthermore, may have the energy band gap higher than that of the first conductivity type semiconductor layer 40. In addition, the first and second intermediate layers 55 and 57 may have the energy band gap higher than those of some regions of the second conductivity type semiconductor region 85, and in particular, may have the energy band gap higher than that of the second conductivity type semiconductor layer 80 that an ohmic electrode contacts.

The second VGL 53 may be a single layer or a plurality of layers, and may have a superlattice structure, but the inventive concepts are not necessarily limited thereto. The second VGL 53 may be formed of InGaN/GaN or GaN or InGaN, and for example, it may be InGaN/GaN containing In to have an energy band gap corresponding to an energy of a wavelength of 405nm or less. In this case, the second VGL 53 may grow relatively slowly along a V-pit structure formed in the first VGL 51 by using a TEGa source as a Ga source. The second VGL 53 may be grown at a temperature lower than the growth temperature of the first conductivity type semiconductor layer 40, for example, 900°C or lower. The second VGL 53 may be formed to have a thickness of about 1000Å to about 2500Å, and may be doped with impurities. For example, a doping concentration of silicon doped into the second VGL 53 may be 5E17 to 5E18/cm³. The second VGL 53 may have an energy band gap equal to or lower than that of the first conductivity type semiconductor layer 40 or the second conductivity type semiconductor layer 80, and may have the energy band gap higher than that of the well layer.

The active layer 60 may include a plurality of light emitting portions 60b and 60g. A total number of well layers of a first light emitting portion 60b or 60g may be equal to or less than the number of well layers of a second light emitting portion 60r.

For example, the first light emitting portion 60b or 60g may emit blue light or green light, and the second light emitting portion 60r may emit red light. The well layer and a barrier layer of the second light emitting portion 60r may be grown under a pressure within a range of 76 torr to 760 torr, respectively. In addition, a growth temperature of the barrier layer may be equal to or higher than a growth temperature of the well layer. For example, a maximum growth temperature of the barrier layer may be about 150°C to 200°C higher than that of the well layer. A thickness of the barrier layer may be greater than that of the well layer, and a total thickness of the barrier layer may have a thickness within a range of about 100Å to about 200Å.

The first and second light emitting portions 60b and 60g may have a single or multi-quantum well structure, and may include an InGaN or InAlGaN well layer. In an embodiment, the first light emitting portion 60b or 60g may be disposed under the second light emitting portion 60r, and when red light generated by the second light emitting portion 60r is emitted to the outside through the second conductivity type semiconductor layer 80, light loss by the first light emitting portion 60b or 60g may be prevented to increase a light extraction efficiency. In another embodiment, the first light emitting portion 60b or 60g may be disposed on the second light emitting portion 60r. Accordingly, when red light generated by the second light emitting portion 60r is emitted to the outside through the first conductivity type semiconductor layer 40, light loss by the first light emitting portion 60b or 60g may be prevented. In this embodiment, the first light emitting portion 60b or 60g is described as being used together with the second light emitting portion 60r, but the first light emitting portion 60b or 60g may be omitted, and thus, a red light emitting diode emitting red light may be provided.

V pits are formed by the pre-strained layer 50, and thus, strain relief of the active layer 60 occurs. Accordingly, a larger amount of In may be introduced into the active layer 60, and thus, luminous efficiency of red light may be improved in a single LED structure, and multicolor, for example, white may be implemented without a phosphor.

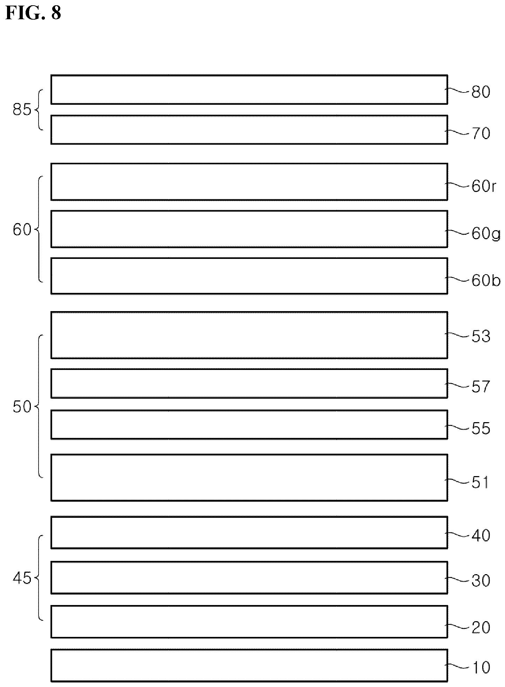

FIG. 8 is a schematic cross-sectional view illustrating a semiconductor stack according to another embodiment of the present disclosure.

Referring to FIG. 8, the semiconductor stack according to this embodiment is similar to that described with reference to FIG. 7, except that the active layer 60 includes three light emitting portions. That is, the semiconductor stack according to this embodiment includes a blue light emitting portion 60b emitting blue light, a green light emitting portion 60g emitting green or yellow light, and a red light emitting portion 60r emitting red light. Each of the light emitting portions 60b, 60g, and 60r may have a single quantum well structure or a multi-quantum well structure.

In this embodiment, although it is shown that the blue light emitting portion 60b is close to the first conductivity type semiconductor layer and the red light emitting portion 60r is close to the second conductivity type semiconductor layer 80, positions of the light emitting portions 60b, 60g, and 60r may be changed depending on a device type. Meanwhile, a total number of well layers of the blue light emitting portion 60b and the green light emitting portion 60g may be equal to or less than the number of well layers of the red light emitting portion 60r.

The blue light emitting portion 60b may emit light having a peak wavelength within a range of 410nm to 495nm, the green light emitting portion 60g may emit light having a peak wavelength within a range of 505m to 605nm, and the red light emitting portion 60r may emit light having a peak wavelength within a range of 610nm to 680nm. Furthermore, in this embodiment, the green light emitting portion 60g is described as emitting single light, without being limited thereto, and it may include a green sub-light emitting portion emitting light having a peak wavelength within a range of 505nm to 550nm and a yellow sub light emitting portion emitting light having a peak wavelength within a range of 550nm to 605nm.

By making the green light emitting portion 60g include the well layers emitting light of different peak wavelengths, a crystallinity quality of the red light emitting portion formed thereon may be improved, and thus, the red light emitting portion with high efficiency may be provided.

In an embodiment, an indium content of the well layers of the active layer 60 may gradually increase from the first conductivity type semiconductor layer 40 toward the second conductivity type semiconductor layer 80. In addition, energy band gaps of the well layers of the active layer 60 may gradually decrease from the first conductivity type semiconductor layer 40 toward the second conductivity type semiconductor layer 80. Furthermore, the well layers of the active layer 60 may be disposed such that a refractive index gradually increases from the first conductivity type semiconductor layer 40 toward the second conductivity type semiconductor layer 80.

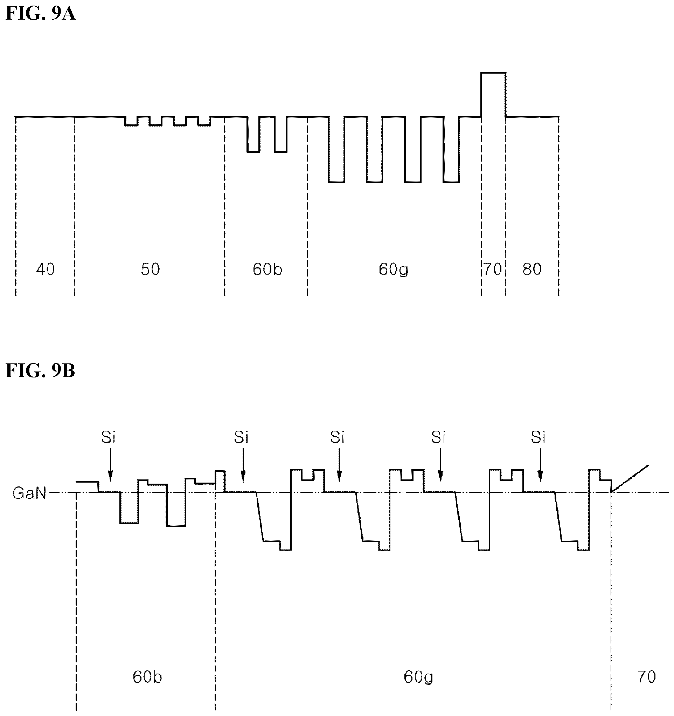

FIG. 9A is a schematic band diagram illustrating a semiconductor stack according to an embodiment of the present disclosure, and FIG. 9B is a band diagram illustrating enlarged portions of the first light emitting portion 60b and the second light emitting portion 60r. In FIGs. 9A and 9B, only conduction bands are shown, and in FIG. 9B, a position of the conduction band of each layer is shown with respect to a conduction band of GaN.

Referring to FIGs. 9A and 9B, the semiconductor stack according to this embodiment includes an active layer 60 including the first light emitting portion 60b and the second light emitting portion 60r. Well layers and barrier layers of each of the first and second light emitting portions 60b and 60r are configured to emit light emitted from the first light emitting portion 60b and the second light emitting portion 60r with a high efficiency.

A first barrier layer of the first light emitting portion 60b may include a GaN layer, and other barrier layers may include an AlGaN layer. The GaN layer of the first barrier layer of the first light emitting portion 60b may be doped with an n-type impurity, for example, Si, and a doping concentration may be within a range of, for example, 5E18/cm³ to 8E18/cm³. No intentional doping is performed on the other barrier layers and the well layers. The first barrier layer may also include a hole blocking layer, which may be formed of an AlGaN layer. The hole blocking layer may be disposed at a boundary between a pre-strained layer 50 and the first light emitting portion 60b. Meanwhile, the barrier layers disposed between the well layers of the first light emitting portion 60b may be formed of an AlGaN layer. Specifically, each of the barrier layers may include a low-temperature AlGaN capping layer and a high-temperature AlGaN barrier layer, and the AlGaN capping layer may have a band gap wider than that of the high-temperature AlGaN barrier layer. The AlGaN capping layer may be made thinner than the high-temperature AlGaN barrier layer. For example, the AlGaN capping layer may be formed to have a thickness of about 1nm, and the high-temperature AlGaN barrier layer to have a thickness of about 35Å. The AlGaN capping layer is grown at a temperature lower than that for growing the high-temperature AlGaN barrier layer, and for example, it may be grown at a same temperature as a growth temperature of the well layer.

Meanwhile, the well layers of the first light emitting portion 60b may be formed of InGaN or InAlGaN, and may have a composition that emits light in a blue region. As shown in FIGs. 9A and 9B, the first light emitting portion 60b may include two well layers having a same energy band gap, but the inventive concepts are not limited thereto, and it may include more well layers, or may include well layers having different energy band gaps from one another. However, the number of well layers of the first light emitting portion 60b may be smaller than that of the well layers of the second light emitting portion 60r. An intensity of red light may be increased by making the number of well layers of the first light emitting portion 60b smaller than the number of well layers of the second light emitting portion 60r.

As shown in FIGs. 9A and 9B, the second light emitting portion 60r may include four well layers between first and last barrier layers, but the number of well layers is not limited thereto. The first barrier layer of the second light emitting portion 60r may include a high-temperature AlN layer and a high-temperature (Al)GaN layer, and the last barrier layer may include an AlGaN layer. The high-temperature AlN layer of the first barrier layer may have a thickness between about 10Å and 20Å, and the (Al)GaN layer may have a thickness of about 130Å. In addition, the barrier layer disposed between the well layers may include a low-temperature AlN capping layer, a low-temperature AlGaN capping layer, a high-temperature AlN capping layer, and an (Al)GaN layer. A GaN capping layer may be used instead of the low-temperature AlGaN capping layer. The low-temperature AlN capping layer compensates strain. The low-temperature AlN capping layer may be grown at a same temperature as a growth temperature of the well layer, and may have a thickness between about 10Å and 20Å. The low-temperature AlGaN capping layer may be grown at a same growth temperature as that of the low-temperature AlN capping layer, and may have a thickness of about 20Å. An Al composition of the low temperature AlGaN capping layer may be within a range of about 20% to about 30%. Meanwhile, the (Al)GaN layer may have a thickness between about 90Å and about 180Å. In the second light emitting portion 60r, (Al)GaN layers of remaining barrier layers other than the last barrier layer may be doped with an n-type impurity, for example, Si. A doping concentration of Si doped in each barrier layer of the second light emitting portion 60r may be lower than that of Si doped in the first barrier layer of the first light emitting portion 60b, and for example, it may be within a range of 5E17/cm³ to 1E18/cm³.

Meanwhile, a thickness of each well layer of the second light emitting portion 60r may be thicker than that of each well layer of the first light emitting portion 60b. For example, the thickness of each well layer of the second light emitting portion 60r may be within a range of about 25Å to about 40Å. Furthermore, each well layer of the second light emitting portion 60r may include a composition grading layer, and may include layers having different In compositions. For example, the well layer of the second light emitting portion 60r may include the composition grading layer, a first composition layer in which a composition thereof is maintained on the composition grading layer, and a second composition layer having an In content different from that of the first composition layer. The composition grading layer may increase an In composition from about 1% to about 30%. An In composition ratio of the first composition layer may be about 30%. The second composition layer having a highest In content may have an In composition ratio of about 50%, and may be disposed in a dot shape. For example, the composition grading layer may have a thickness within a range of about 7Å to 10Å, the first composition layer may have a thickness within a range of 20Å to 22Å, and the second composition layer may have a thickness of about 5Å.

Meanwhile, a thickness of each barrier layer of the second light emitting portion 60r may be greater than that of each barrier layer of the first light emitting portion 60b.

In this embodiment, it is described that the second light emitting portion 60r is disposed on the first light emitting portion 60b, but a light emitting portion emitting green or yellow light may be further disposed between the first light emitting portion 60b and the second light emitting portion 60r.

An electron blocking layer 70 may be disposed to prevent electrons from flowing into a second conductivity type semiconductor layer 80 without recombination. The electron blocking layer 70 may be formed of an AlGaN layer, and as shown in FIG. 9B, it may be a grading layer in which a composition of Al gradually increases.

In this embodiment, the second light emitting portion 60r emitting red light is disposed adjacent to the second conductivity type semiconductor layer 80, and the first light emitting portion 60b emitting blue light is disposed adjacent to a first conductivity type semiconductor layer. Through this, a crystallinity quality of a red light emitting portion may be improved, and further, a light emitting device with improved visibility may be provided.

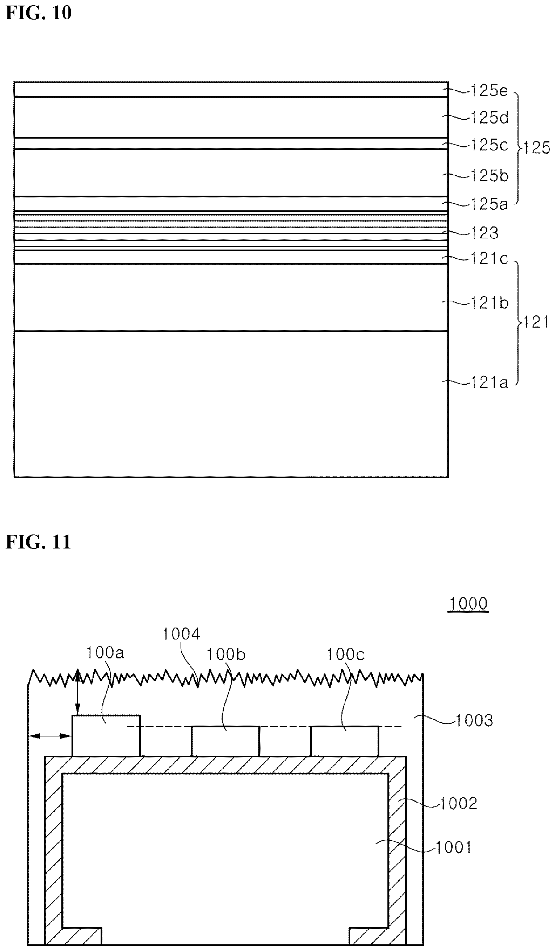

FIG. 10 is a schematic cross-sectional view illustrating a structure of a semiconductor stack of a red light emitting device according to an embodiment of the present disclosure.

Referring to FIG. 10, the semiconductor stack includes a first conductivity type semiconductor layer 121, an active layer 123, and a second conductivity type semiconductor layer 125. Each layer may have a multilayer structure. For example, the first conductivity type semiconductor layer 121 may include a first conductivity type window layer 121a, a first conductivity type cladding layer 121b, and a first conductivity type waveguide layer 121c, and the second conductivity type semiconductor layer 125 may include a second conductivity type waveguide layer 125a, a second conductivity type cladding layer 125b, a second conductivity type intermediate layer 125c, a second conductivity type window layer 125d, and a second conductivity type contact layer 125e. The active layer 123 may have a multi-quantum well structure including a barrier layer and a well layer. In this embodiment, the first conductivity type represents an n-type and the second conductivity type represents a p-type, or it may be vice versa.

The first conductivity type window layer 121a may be formed of InAlGaP. For example, the first conductivity type window layer 121a may have a composition formula of Inₓ(Al_{z}Ga_{(1-z)})_{y}P (where x+y=1). The first conductivity type window layer 121a may have a thickness of, for example, about 1.6um to about 2.2um. A difference between a x value and a y value is formed within 15%, so that a gap difference between other layers disposed under and over may be relieved. A composition (z) of Al may have a value greater than a composition of Ga. Preferably, an Al content may have a composition 1.1 times or more of a Ga content. Accordingly, it is possible to reduce defects in the layer by adjusting a lattice balance between elements forming the layer.

The first conductivity type cladding layer 121b may be formed of InₓAl₍₁₋ₓ₎P. For example, in the first conductivity type cladding layer 121b, a content difference between In and Al of InₓAl₍₁₋ₓ₎P may be formed within 15%. Accordingly, it is possible to reduce defects in the layer by adjusting a lattice balance between elements forming the layer. The first conductivity type cladding layer 121b may have a thickness of, for example, about 250nm to about 350nm.

The first conductivity type waveguide layer 121c may be formed of Inₓ(Al_{z}Ga_{(1-z)})_{y} P (where x+y=1). For example, an Al content in the first conductivity type waveguide layer 121c may be three times greater than a Ga content. A difference between a x value and a y value may be formed within 15%. Accordingly, it is possible to relieve the gap difference between other layers that are disposed under and over, and to reduce the defects in the layer by adjusting the lattice balance between elements forming the layer. The first conductivity type waveguide layer 121c may have a thickness of, for example, about 50nm to about 100nm.

The active layer 123 includes a barrier layer and a well layer, and the barrier layer may be formed of InAlGaP and the well layer may be formed of InGaP. For example, the barrier layer may have a composition formula of Inₓ(Al_{z}Ga_{(1-z)})_{y}P (where x+y=1), and the well layer may have a composition formula of InₓGa₍₁₋ₓ₎P. The barrier layer may have a thickness of about 5nm to 6nm, and the well layer may have a thickness of about 6nm to about 7nm. Alternatively, an Al content of the barrier layer may be 3 times or more than a Ga content. A difference between a x value and a y value may be formed within 15%. A composition of the well layer of the active layer 123 may be adjusted to emit red light within a range of 630nm to 680nm. The active layer 123 may include, for example, pairs of barrier layers and well layers stacked over 15 cycles. The well layer may be formed such that a difference between the In content and the Ga content is less than 15%. Accordingly, it is possible to reduce defects in the layer by adjusting a lattice balance between elements forming the layer.

The second conductivity type waveguide layer 215a may be formed of Inₓ(Al_{z}Ga_{(1-z)})_{y}P (where x+y=1). For example, an Al content in the second conductivity type waveguide layer 125a may be three times greater than a Ga content. Alternatively, a difference between a x value and a y value may be formed within 15%. The second conductivity type waveguide layer 125a may have a thickness of, for example, about 50nm to about 100nm. The second conductivity type waveguide layer 125a may be thicker than the first conductivity type waveguide layer 121c. Alternatively, a thickness of the first conductivity type waveguide layer 121c may be greater than that of the second conductivity type waveguide layer 125a. The thicknesses of the first conductivity type waveguide layer 121c and the second conductivity type waveguide layer 125a are set to be different, and path lengths of an upper portion and a lower portion through which generated light has to pass, thereby increasing a light extraction effect by constructive interference.

The second conductivity type cladding layer 125b may be formed of InAlP. For example, the second conductivity type cladding layer 125b may have a compositional formula of InₓAl₍₁₋ₓ₎P. The second conductivity type cladding layer 125b may have a thickness of, for example, about 220nm to about 320nm. The second conductivity type cladding layer 125b may be thinner than the first conductivity type cladding layer 121b. The second conductivity type cladding layer 125b may have a composition difference of less than 15% between In and Al. Accordingly, it is possible to reduce defects in the layer by adjusting a lattice balance between elements forming the layer.

The second conductivity type intermediate layer 125c may be formed of Inₓ(Al_{z}Ga_{(1-z)})_{y}P (where x+y=1). For example, the second conductivity type intermediate layer 125c may be formed of In0.5(Al0.4Ga0.6)0.5P. The second conductivity type intermediate layer 125c may have a thickness of 15nm to 25nm. A difference between a x value and a y value is formed within 15%, so that a gap difference between other layers disposed under and over may be relieved. A composition (z) of Al may have a value smaller than a composition of Ga. Preferably, a Ga content may have a composition 1.3 times or more of an Al content. Therefore, the second conductivity type intermediate layer 125c serves to buffer a stress caused by a difference in lattice constant between the layers disposed under and over the second conductivity type intermediate layer 125c.

The second conductivity type window layer 125d may be formed of GaP. The second conductivity type window layer 125d may have a thickness of about 170nm to about 270nm. The second conductivity type window layer 125d assists current spreading. A thickness of the second conductivity type window layer 125d may be smaller than that of the first conductivity type window layer 121a. Preferably, the thickness of the second conductivity type window layer 125d may be 10% to 30% of the thickness of the first conductivity type window layer 121a. Accordingly, since a speed at which electrons and holes reach the active layer 123 may be balanced, a radiation efficiency may be improved.

The second conductivity type contact layer 125e may be formed of GaP. The second conductivity type contact layer 125e is formed of GaP having a same composition as the second conductivity type window layer 125d, but is doped with p-type impurities at a higher concentration than that of the second conductivity-type window layer 125d for ohmic contact. The second conductivity type contact layer 125d may have a thickness of about 15nm to about 25nm, for example.

A sum of the thicknesses of the second conductivity type intermediate layer 125c, the second conductivity type window layer 125d, and the second conductivity type contact layer 125d may be greater than 1/10 of the thickness of the first conductivity type window layer 121a. In addition, a sum of the thicknesses of the first conductivity type cladding layer 121b and the first conductivity type waveguide layer 121c may be greater than a sum of the thicknesses of the second conductivity type waveguide layer 125a and the second conductivity type cladding layer 125b.

Meanwhile, a surface roughness is formed on a surface of the first conductivity type window layer 121a of this embodiment, and since this has been described with reference to FIGs. 2A to 2D, a detailed description thereof will be omitted.

FIG. 11 is a schematic cross-sectional view illustrating a light emitting module 1000 having a red light emitting device according to an embodiment of the present disclosure.

Referring to FIG. 11, the light emitting module 1000 may include a circuit board 1001, a red light emitting device 100r, a green light emitting device 100g, a blue light emitting device 100b, and a molding member 1003.

The circuit board 1001 may have a circuit pattern for supplying electricity to the light emitting devices 100r, 100g, and 100b. The circuit board 1001 may have a multi-layered interconnection pattern. In addition, it may have bonding pads 1002 for mounting the light emitting devices 100r, 100g, and 100b. Further, the circuit board 1001 may have exposed pads in which the bonding pads 1002 for mounting the light emitting devices on a panel substrate or the like extend to a bottom surface of the circuit board 1001. The bonding pads 1002 may extend to the bottom surface while enclosing a side surface of the circuit board 1001 to surround at least a portion of the circuit board 1001. Accordingly, it may play a role of firmly securing layers forming the circuit board 1001 such that they are not peeled off.

The red light emitting device 100r may be the light emitting device 100 described with reference to FIGs. 1A and 1B, and a detailed description thereof is omitted to avoid redundancy. The red light emitting device 100r may be a vertical light emitting device as described with reference to FIGs. 1A and 1B, without being limited thereto, and may be a flip chip type light emitting device. A bonding wire may electrically connect the bonding pad 131 of the light emitting device 100 and the bonding pad on the circuit board 1001. A welding portion of the bonding wire may be formed on the bonding pad 131.

In a case of the green light emitting device 100g, semiconductor layers may include indium gallium nitride (InGaN), gallium nitride (GaN), gallium phosphide (GaP), aluminum gallium indium phosphide (AlGaInP), or aluminum gallium phosphide (AlGaP). In a case of the blue light emitting device 100b, semiconductor layers may include gallium nitride (GaN), indium gallium nitride (InGaN), or zinc selenide (ZnSe). The green light emitting device 100g and the blue light emitting device 100b may be a vertical, lateral or flip chip type light emitting device.

In this embodiment, heights of upper surfaces of the light emitting devices 100r, 100g, and 100b may be different from one another. In particular, the height of the upper surface of the red light emitting device 100r may be higher than those of the other light emitting devices 100b and 100g.

The molding member 1003 covers the light emitting devices 100r, 100g, and 100b. The molding member 1003 may be formed of a single layer, or may be formed of multiple layers. In addition, the molding member 1003 may include a light diffuser, and may further include a black matrix. An upper surface of the molding member 1003 may include regions having different heights, and may include a groove portion 1004. The groove portion 1004 may include an inclined surface, and may further include a curved surface. The molding member 1003 may have a thickness larger than that of at least one light emitting device 100r, 100g, or 100b, and may be thicker than a thickness of the molding member disposed on one side of the at least one light emitting device 100r, 100g, or 100b.

In another embodiment, the groove portion 1004 may be formed to a depth equal to or greater than half of the thickness of the molding member 1003. In this case, in cross-sectional view, the groove portion 1004 may include surfaces perpendicular to an upper surface of the circuit board 1001, and may include a curved groove between the vertical surfaces which are disposed to face each other.

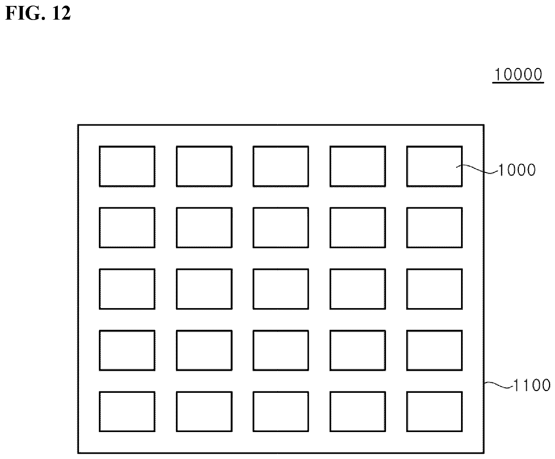

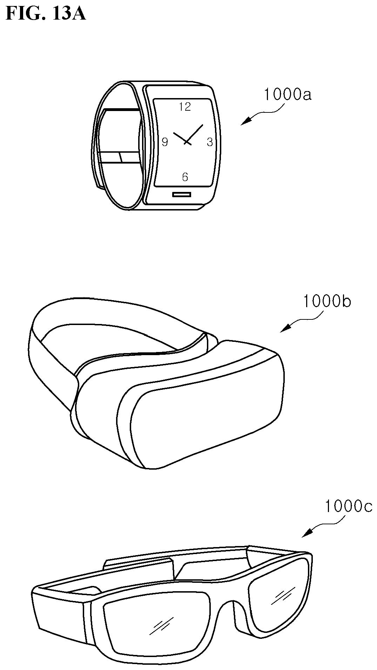

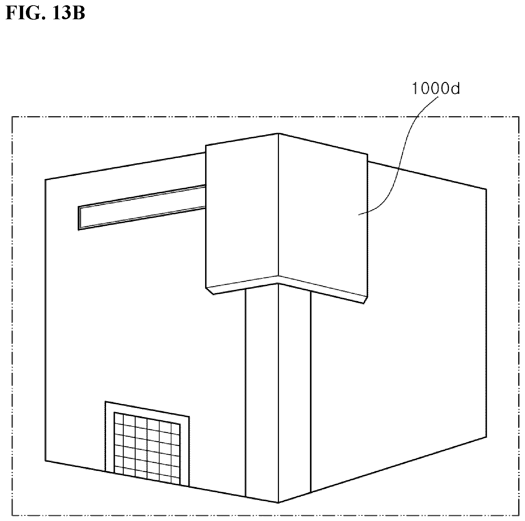

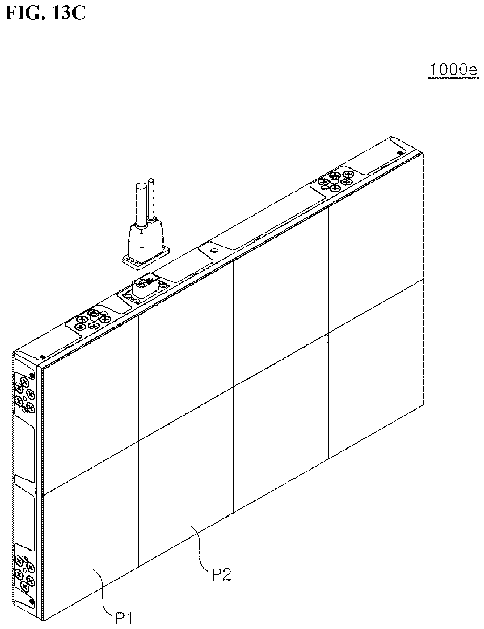

FIG. 12 is a schematic plan view illustrating a display apparatus 10000 according to an embodiment of the present disclosure, and FIGs. 13A, 13B, and 13C are schematic perspective views illustrating various display apparatuses 1000a, 1000b, 1000c, 1000d, and 1000e according to an embodiment of the present disclosure.

Referring to FIG. 12, the display apparatus 10000 may include a panel substrate 1100 and a plurality of light emitting modules 1000. The display apparatus 10000 is not particularly limited, but may include a smart watch 1000a, a wearable display apparatus 1000b such as a VR headset or glasses, or an AR display apparatus 1000c such as augmented reality glasses, or an indoor or outdoor display apparatus 1000d or 1000e such as a micro LED TV or signage. The panel substrate 1100 and the plurality of light emitting modules 1000 may be disposed in the display apparatuses 1000a through 1000e.

The panel substrate 1100 may be formed of a material such as polyimide (PI), FR4, or glass, and may include a circuit for driving a passive matrix or an active matrix. In an embodiment, the panel substrate 1100 may include interconnections and resistors therein. In another embodiment, the panel substrate 1100 may include interconnections, transistors, and capacitors. In addition, the panel substrate 1100 may have pads electrically connected to circuits on its upper surface.

The plurality of light emitting modules 1000 may be arranged on the panel substrate 1100. The light emitting modules 1000 may be disposed at an interval from one another, or may be disposed to be in close contact with one another. In this embodiment, it is shown that the light emitting modules 1000 are directly disposed on the panel substrate 1100, but the inventive concepts are not limited thereto. The plurality of light emitting modules 1000 may be arranged on another circuit board such as an interposer, and a plurality of interposers may be disposed on the panel substrate 1100. In addition, a display apparatus may be provided by disposing the plurality of light emitting modules 1000 on a cabinet substrate and mounting the plurality of cabinet substrates on which the light emitting modules are arranged on a frame or the like.

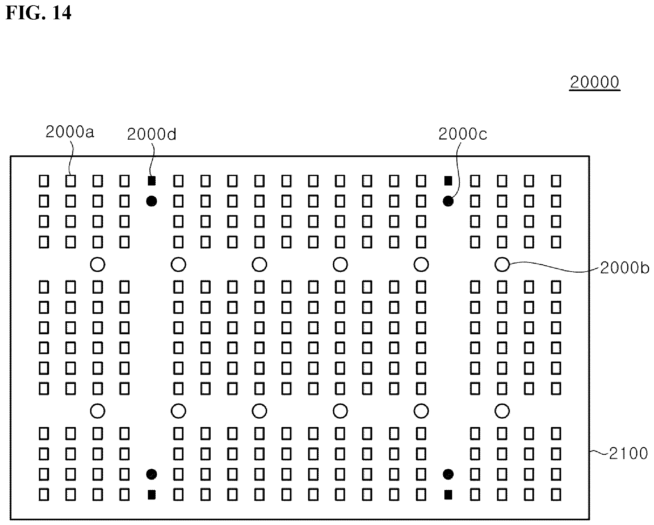

FIG. 14 is a schematic cross-sectional view illustrating a plant lighting apparatus 20000 according to an embodiment of the present disclosure.

Referring to FIG. 14, the plant lighting apparatus 20000 according to this embodiment includes a panel substrate 2100 and light emitting devices 2000a through 2000d.

The panel substrate 2100 may have a circuit for supplying electricity to the light emitting devices 2000a through 2000d. In addition, the panel substrate 2100 may have a reflection sheet or reflection layer for reflecting light on its surface. The panel substrate 2100 may have an approximately a quadrangular shape.

The light emitting devices 2000a through 2000d emitting light of different wavelengths may be disposed on the panel substrate 2100. The light emitting devices 2000a through 2000d may have a package structure, without being limited thereto.

A first light emitting device 2000a may emit white light. For example, the first light emitting device 2000a may include a phosphor together with a blue light emitting diode. The blue light emitting diode may emit light having a peak wavelength within a range of 430nm to 460nm, for example. A plurality of first light emitting devices 2000a is arranged on the panel substrate 2100. The first light emitting devices 2000a may be arranged in a largest number compared to the other light emitting devices 2000b through 2000d, and may be arranged in a larger number than a total number of the other light emitting devices 2000b through 2000d.

In this embodiment, the first light emitting devices 2000a may emit white light having substantially similar temperatures, without being limited thereto. For example, the first light emitting devices 2000a may include light emitting devices emitting white light having different color temperatures. For example, the first light emitting devices 2000a may include light emitting devices emitting warm white light and light emitting devices emitting natural white light. Natural white light promotes a growth of plants to increase a growth rate, and warm white light makes fruits bigger and the growth condition better. The first light emitting device 2000a may be dimmed. A second light emitting device 2000b may be a light emitting device emitting red light. The second light emitting device 2000b may include, for example, the light emitting device 100 described with reference to FIGs. 1A and 1B. Herein, the second light emitting device 2000b may emit light having a peak wavelength within a range of 630nm to 680nm, for example. Light with the peak wavelength within this range increases crop yield and is more effective in combination with blue light. The peak wavelength of light emitted from the second light emitting device 2000b may be longer than that of blue light emitted from the first light emitting device 2000a by 100nm or more. A separation gap of the peak wavelengths is set to be 100nm or more, which supplies more accurate light of each color or wavelength to a plant, and thus, it is effective for plant growth. The second light emitting device 2000b may be dimmed.

A third light emitting device 2000c may emit longer wavelength red light that emits light having a peak wavelength within a range of 710nm to 750nm, for example. The third light emitting device 2000c promotes flowering by promoting phytochrome that responds to infrared light. The third light emitting device 2000c may be dimmed.

A fourth light emitting device 2000d may emit near-ultraviolet light that emit light having a peak wavelength within a range of 380nm to 410nm, for example. The peak wavelength of light emitted from the fourth light emitting device 2000d may be shorter than that of blue light emitted from the first light emitting device 2000a by 50nm or more. The fourth light emitting device 2000d may include a gallium nitride-based light emitting diode. The fourth light emitting device 2000d promotes the growth of plants, and further increases a production of useful materials. The fourth light emitting device 2000d may be dimmed.

The light emitting devices 2000a through 2000d of this embodiment may be driven by alternating current or direct current, and may be dimmed. Meanwhile, the light emitting devices 2000a through 2000d may be connected through a plurality of channels. In an embodiment, the first through fourth light emitting devices 2000a through 2000d may be connected to different channels, and accordingly, a same type of light emitting devices may be selectively driven. In another embodiment, the first through fourth light emitting devices 2000a through 2000d may be combined with one another and connected through the plurality of channels. For example, channels may be configured according to a mode optimized for effectively obtaining a life time of plant growth or a desired useful material, and the channels may be selectively driven according to each mode.

In this embodiment, the number of first light emitting devices 2000a is a largest, and the number of first light emitting devices 2000a may be larger than a sum of the numbers of second light emitting devices 2000b and third light emitting devices 2000c. In addition, the sum of the numbers of the second light emitting devices 2000b and the third light emitting devices 2000c may be larger than the number of the fourth light emitting devices 2000d.

The second light emitting device 2000b may be disposed between the first light emitting devices 2000a. Alternatively, the third light emitting device 2000c may be disposed between the first light emitting devices 2000a. Alternatively, the fourth light emitting device 2000d may be disposed between the first light emitting devices 2000a. By disposing the second light emitting devices 2000b, the third light emitting device 2000c, or the fourth light emitting device 2000d between the first light emitting devices 2000a having the largest number, light emitted from the second through fourth light emitting devices 2000b, 2000c, and 2000d may reach a plant together with the first light emitting device 2000a without being uneven.

In another embodiment, light emitting devices disposed on the panel substrate 2100 may be disposed by combining a plurality of light emitting devices having different peak wavelengths. For example, two groups of each group of light emitting devices 2000a through 2000d may be disposed on the panel substrate 2100 such that two wavelengths can be generated on the panel substrate 2100. Alternatively, three groups of each group of the light emitting devices 2000a through 2000d may be disposed on the panel substrate 2100 such that three wavelengths can be generated on the panel substrate 2100. Alternatively, four groups of light emitting devices 2000a through 2000d may be disposed on the panel substrate 2100 such that four wavelengths can be generated on the panel substrate 2100. Accordingly, by selecting and arranging a group of light emitting devices 2000a through 2000d according to a desired plant enhancement effect or purpose, an effect acting on the plant may be maximized.

Although some embodiments have been described herein, it should be understood that these embodiments are provided for illustration only and are not to be construed in any way as limiting the present disclosure. It should be understood that features or components of an exemplary embodiment can also be applied to other embodiments without departing from the spirit and scope of the present disclosure.

## Claims

1. A red light emitting device, comprising:
a first conductivity type semiconductor layer;
a second conductivity type semiconductor layer; and
an active layer disposed between the first conductivity type semiconductor layer and the second conductivity type semiconductor layer, wherein:
a first conductivity type semiconductor layer includes a plurality of protrusions on a surface, and
the plurality of protrusions includes protrusions having an inclined side surface.

2. The red light emitting device of claim 1,
wherein the plurality of protrusions includes a protrusion spaced apart from other protrusions and protrusions contacting neighboring protrusions.

3. The red light emitting device of claim 2,
wherein the protrusions contacting neighboring protrusions include protrusions having a continuous upper surface.

4. The red light emitting device of claim 3,
wherein the connection portion of the protrusions having the continuous upper surface has a width smaller than a maximum width of the protrusions.

5. The red light emitting device of claim 2,
wherein the protrusions contacting neighboring protrusions include protrusions in which V-shaped grooves formed therebetween.

6. The red light emitting device of claim 1, further comprising:
a bonding pad disposed on the first conductivity type semiconductor layer and extension electrodes extending from the bonding pad.

7. The red light emitting device of claim 6,
wherein the bonding pad is disposed near an edge or a vertex of the first conductivity type semiconductor layer.

8. The red light emitting device of claim 6,
wherein the extension electrodes include first extension electrodes extending in a longitudinal direction from one edge of the first conductivity type semiconductor layer to an opposite edge thereof, and second extension electrodes connecting end portions of the first extension electrodes.

9. The red light emitting device of claim 8,
wherein at least one of the second extension electrodes is connected to the bonding pad.

10. The red light emitting device of claim 9,
wherein the second extension electrodes connected to the bonding pad have a width that narrows as a distance from the bonding pad increases.

11. The red light emitting device of claim 6, wherein:
the bonding pads and the extension electrodes are disposed on a flat region of the first conductivity type semiconductor layer, and
the protrusions are arranged in a region surrounded by the flat region.

12. The red light emitting device of claim 1, further comprising:
a current blocking layer disposed under the second conductivity type semiconductor layer,
wherein the current blocking layer includes at least two insulation layers having different refractive indices.

13. The red light emitting device of claim 12,
wherein the current blocking layer includes a SiO₂ layer and a Nb₂O₅ layer.

14. The red light emitting device of claim 12, further comprising:
a substrate;
a first metal layer disposed on the substrate;
a second metal layer covering the current blocking layer; and
a bonding metal layer bonding the first metal layer and the second metal layer.

15. The red light emitting device of claim 14, wherein:
the current blocking layer has at least one opening, and
the second metal layer is electrically connected to the second conductivity type semiconductor layer through the opening of the current blocking layer.

16. The red light emitting device of claim 15, further comprising:
an ohmic electrode in ohmic contact with the second conductivity type semiconductor layer, wherein:
the opening of the current blocking layer exposes the ohmic electrode, and
the second metal layer is connected to the ohmic electrode.

17. The red light emitting device of claim 15,
wherein a width of the opening is greater than a width of one of the protrusions.

18. A light emitting module, comprising:
a circuit board; and
a red light emitting device, a green light emitting device, and a blue light emitting device disposed on the circuit board,
wherein the red light emitting device is the red light emitting device of claim 1.

19. A plant lighting apparatus, comprising:
a panel substrate; and
light emitting devices disposed on the panel substrate, wherein:
the light emitting devices include first light emitting devices emitting white light, second light emitting devices emitting red light within a range of 630nm to 680nm, and third light emitting devices emitting longer wavelength red light within a range of 710nm to 750nm, and fourth light emitting devices emitting near ultraviolet light within a range of 380nm to 410nm, and
the second light emitting devices include the red light emitting device of any one of claims 1 to 17.

20. The plant lighting apparatus of claim 19,
wherein a peak wavelength of red light emitted from the second light emitting device is longer than a peak wavelength of blue light emitted from the first light emitting device by 100nm or more, and a peak wavelength of near-ultraviolet light emitted from the fourth light emitting device is shorter than the peak wavelength of blue light emitted from the first light emitting device by 50nm or more.
